Europäisches Patentamt

European Patent Office

Office européen des brevets

(11) Publication number: **0 162 830**
**A1**

(12) **EUROPEAN PATENT APPLICATION**

(21) Application number: **85870055.2**

(22) Date of filing: **18.04.85**

(51) Int. Cl.⁴: **H 01 L 29/167**

(30) Priority: **19.04.84 US 602047**

(43) Date of publication of application:
**27.11.85 Bulletin 85/48**

(84) Designated Contracting States:
**DE FR GB IT**

(71) Applicant: **Monsanto Company**
**Patent Department 800 North Lindbergh Boulevard**
**St. Louis Missouri 63167(US)**

(72) Inventor: **Chiou, Herng-Der**
**11315 Momarte Lane**
**Creve Coeur Missouri 63146(US)**

(72) Inventor: **Moody, Jerry Wofford**
**3317 West Adams Street**
**Saint Charles Missouri 63301(US)**

(74) Representative: **Lunt, John Cooper et al,**
**Monsanto Europe S.A. Patent Department Avenue de**
**Tervuren 270-272 Letter Box No 1**
**B-1150 Brussels(BE)**

(54) **Improved semiconductor substrates.**

(57) Semiconductor substrate materials, such as silicon, useful in the manufacture of electronic devices such as integrated circuits, containing oxygen are doped with sufficient nitrogen to enhance thermal precipitation of the oxygen.

EP 0 162 830 A1

Croydon Printing Company Ltd

## IMPROVED SEMICONDUCTOR SUBSTRATES
### BACKGROUND OF THE INVENTION
#### FIELD OF THE INVENTION

This invention relates to improved semiconductor substrate materials, such as silicon wafers, useful in the manufacture of integrated circuit devices. Specifically, this invention is directed to semiconductor substrate materials containing oxygen which exhibit enhanced oxygen precipitation.

In the manufacture of integrated circuit devices on silicon wafers, the presence of and introduction of defects, contaminants and impurities near the device creates excessive current leakages which greatly affect the yield of usable devices obtained. The art has recognized that the deleterious defects, contaminants and impurities can be to some extent relocated to non-harmful regions in the substrate material away from the device formation region. The methods and processes for diffusing and trapping the defects, contaminants and impurities away from the active device region both prior to and during device formation are termed gettering in the electronics industry and art.

#### DESCRIPTION OF THE PRIOR ART

Several techniques and processes for gettering in semiconductor materials to improve device yields have been disclosed in the art. Known gettering techniques and processes for semiconductor materials can be generally classified as based on external or internal means.

External gettering involves modifying the backside surface of the wafer through mechanical damage, additional layers or impurity implantation for providing sites to which the defects, contaminants and impurities are attracted and trapped.

More recently, the gettering effect of oxygen contained in the substrate material has been reported in "Solid State Technology", July 1981, pages 55-61, and is referred to as internal gettering. Oxygen is present in Czochralski grown silicon as it is introduced to the crystal from the dissolution of the quartz crucible employed to hold the silicon melt during crystal pulling. The precipitation of oxygen contained in the substrate material can form useful sites for gettering deleterious defects, contaminants and impurities.

In the manufacture of devices, the active region of the substrate material where the devices are formed must be free of gettering sites. Thus, a zone about 5-25 microns and preferably about 10-20 microns in depth from the device surface of the wafer free of gettering sites must be created to prevent device yield loss from defect interference. The oxygen concentration in a substrate material can be reduced near the surface through outward diffusion prior to precipitation and reduce and/or prevent the formation of gettering sites in this region.

The oxygen present in the substrate material must be in a precipitated state to provide lattice strain which gives rise to dislocation loops and stacking faults that provide gettering sites. Precipitation of oxygen in semiconductor substrate materials such as silicon is extremely difficult to achieve when the substrate material is highly doped with impurities such as antimony or phosphorous to provide desired electrical properties or when the oxygen content is low, i.e. less than about 30 ppma.

With the rapidly advancing device manufacturing technology and particularly with respect to complex and lengthy processing steps, increased circuit density and total circuit size on a wafer, it has become apparent improvements are needed in the gettering capabilities of substrates to provide effective gettering throughout the device processing steps in order to achieve an acceptable yield of good devices per wafer. Thus, the provision of a semiconductor or substrate which exhibits enhanced precipitation of oxygen would be advantageous and cost effective for the electronic device industry.

## SUMMARY OF THE INVENTION

Typical objects of this invention are to provide:

1. a semiconductor substrate having improved internal gettering capabilities;

2. a semiconductor substrate which provides enhanced oxygen precipitation and improved internal gettering capabilities; and

3. a semiconductor substrate exhibiting enhanced gettering capabilities throughout device processing cycles.

Other objects, characteristics and advantages of this invention will become apparent to those skilled in the art from this disclosure and appended claims.

In accordance with this invention, the improved semiconductor substrate comprises single crystalline silicon containing 0.1 to 200 ppba of nitrogen and preferably 1 to 80 ppba of nitrogen. The enhanced oxygen precipitation is imparted by the presence of nitrogen. The nitrogen is introduced to the silicon crystal during Czochralski crystal growth. The oxygen in the crystal is caused to precipitate by thermal treatment.

The basis for this invention is the presence of nitrogen in oxygen containing Czochralski grown semiconductor crystals. The presence of nitrogen is effective for enhancing precipitation of the oxygen contained in the crystal regardless of the oxygen concentration. The nitrogen enhances formation of a high density of small oxygen precipitates in the crystal. Oxygen concentrations in crystals generally range from 5 to 50 ppma and preferably from 10 to 40 ppma. Generally, lower oxygen contents are desirable for many applications to maintain substrate strength and reduce warpage. As noted above, Czochralski grown silicon crystals contain oxygen dispersed throughout the crystal which is introduced by dissolution of the quartz crucible holding the silicon melt. Heretofore, nitrogen has not been a noticeable component present in oxygen containing Czochralski grown silicon crystals. However, a paper by T. Abe et al titled "Impurities in Silicon Single Crystal" --a current view -- published at pages 54 through 65 in Semiconductor Silicon, ECS, 1981 reports on a study of nitrogen-doped float zone silicon crystals. Float-zone silicon crystals, as reported in such study, do not contain oxygen in appreciable quantities, generally less than 2 ppma. Thus, Applicants' discovery of the effect of nitrogen on oxygen precipitation in silicon crystals provides a valuable contribution toward improved semiconductor substrates for today's device manufacturing industry.

## DESCRIPTION OF PREFERRED EMBODIMENTS

In the following example, portions of Czochralski grown silicon crystals having different oxygen contents and doped with various levels of nitrogen are compared with comparable non-nitrogen doped Czochralski grown silicon crystals.

All of the crystals used are 100 mm diameter, (100) orientation doped with boron to provide a resistivity from 10 to 20 ohm-cm and grown by the Czochralski pulling technique. The crystals are pulled from a 26 Kg melt contained in a 13 inch (33 cm) quartz crucible. The nitrogen-doped crystals are prepared by adding selected weights of 99.9+% pure electronic grade silicon nitride to the silicon in the crucible prior to melt down.

Each crystal is processed by standard techniques of sawing, lapping, etching and polishing. Polished wafers from the same relative axial position of each crystal are used for the comparative evaluation.

The interstitial oxygen concentration(Oi) is detected by using an IBM Instruments 98 Fourier Transform Infrared (FTIR) spectrometer. The 9 micrometer absorption band due to interstitial oxygen in silicon is measured with the FTIR. The interstitial oxygen concentration in ppma (1 ppma = $5 \times 10^{16}$ atom/$cm^3$) is:

Oi in ppma = $9.63\alpha$

where $\alpha$ is the absorption coefficient. The 9.63 is the conversion coefficient (ASTM F121-76).

The amount of oxygen in ppma precipitated in a given heat treatment is the difference in the measured interstitial oxygen concentration prior to and after the heat treatment.

A Tempress 200 series horizontal diffusion furnace is used for the precipitation heat treatment. The furnace controlls the temperature within $\pm$ 1.00 C. has a hot zone of about 16 inches (40.6 cm) and uses a 150 mm diameter quartz tube. The wafers are placed vertically in a quartz boat. For the heat treatment at 1000°C., the quartz boat is pushed into the hot zone at 800 C. at 6 inches (15.2 cm)/min. then the temperature is ramped up at 10 C./min. to the heat treating temperature. After the heat treatment the temperature is ramped down to 800 C. and the quartz is pulled out of the hot zone. For the heat treatment at 600°C., the hot zone is 600°C. and no temperature ramping is used. In both the 600°C. and 1000°C. heat treatments the furnace atmosphere is dry oxygen.

The initial interstitial oxygen concentration of the wafers measured by FTIR and the average of comparable wafers are reported in the table. Comparable wafers are divided into two groups. The first group is heat treated at 600°C. in dry oxygen for 240 hours and the second group is heat treated at 1000°C. in dry oxygen for 72 hours. After the heat treatment the interstitial oxygen concentration of the wafers is again measured by FTIR. The difference in Oi concentration (Δ Oi) before and after the noted heated treatment is calculated and the average difference of comparable wafers is shown in the table as the quantity of oxygen precipitated.

TABLE

| WAFER | INITIAL[1] Oi(PPMA) | NITROGEN[2] (PPba) | 600°C. ΔOi(PPMA) | 1000°C. ΔOi(PPMA) |
|---|---|---|---|---|
| A | 27.4 | 0 | 1.5 | 20.0 |
| B | 28.6 | 4.0 | 2.8 | 21.4 |
| C | 28.2 | 8.8 | 3.6 | 21.4 |
| D | 28.8 | 17.5 | 5.5 | 21.8 |
| E | 20.6 | 0 | 0.4 | 3.4 |
| F | 21.2 | 11.0 | 0.5 | 15.8 |
| G | 20.8 | 23.0 | 1.2 | 15.4 |
| H | 18.8 | 56.0 | 1.1 | ·12.7 |

[1] - Wafers A, B, C, & D from crystal at about 20% of melt solidification and wafers E, F, G & H from crystal at about 70% of melt solidification.

[2] - Calculated from silicon melt containing 5 ppma nitrogen (B&F), 10 ppma nitrogen (C&G), and 20 ppma nitrogen (D&H).

From the above data it is readily apparent that the presence of nitrogen in the crystal provides a major effect on precipitation of oxygen in the silicon crystal. The data further indicates for wafers A, B, C and D having a medium oxygen concentration that the oxygen precipitation at the 600°C. heat treatment is dependent upon the nitrogen concentration. About a four fold increase in oxygen precipitation is obtained when 17.5 ppba nitrogen is present. At the 1000°C. heat treatment, the presence of nitrogen regardless of concentration improves the oxygen precipitation greater than 5%. The data for crystals E, F, G and H having a low concentration of oxygen exhibits about a five fold increase in oxygen precipitation at the 1000°C. heat treatment regardless of nitrogen concentration. At the 600°C. heat treatment the oxygen precipitation is increased about three fold at higher nitrogen concentrations.

The enhanced oxygen precipitation obtained by use of this invention provides semiconductor substrates having improved internal gettering capabilities through the provision of greater oxygen precipitates as gettering sites. This invention can be utilized with wafers having a polysilicon layer applied to the backside of the wafer to provide further enhanced gettering capability. The use of polysilicon layers on the wafer backside to enhance gettering is described and claimed in copending applications EP-A-0 120 830 and Serial No. 481,587 filed April 4, 1983. The polysilicon layer on the backside of the wafer generally will be 0.05 to 5.0 micron thick and preferably 0.4 to 1.2 microns thick.

The enhanced precipitation of oxygen in semiconductor substrates by incorporation of nitrogen in accordance with this invention can also improve the strength of the substrates by reducing slip.

The use of nitrogen in semiconductor substrates containing oxygen in accordance with this invention can be used to control oxygen precipitation by selecting

19-21(8319) 0162830

the level of nitrogen present in relation to the
thermal processing conditions for the semiconductor
substrate.

It is to be further understood that changes
and modifications in form and detail of the invention
and specific utilization thereof may be made without
departing from the spirit and scope of the invention
and appended claims.

## WHAT IS CLAIMED IS

1. A semiconductor substrate useful in device manufacturing processes and having capability of gettering defects, contaminants and impurities deleterious to the device away from the active device region comprising a semiconductor material containing oxygen and nitrogen, said nitrogen being present in an amount sufficient to enhance the thermal precipitation in said oxygen.

2. The substrate of Claim 1 wherein the semiconductor material contains 0.1 to 200 ppba nitrogen.

3. The substrate of Claim 1 wherein the semiconductor material contains 1.0 to 80 ppba nitrogen.

4. The substrate of Claim 1 wherein semiconductor material is silicon.

5. The substrate of Claim 1 wherein said semiconductor material has a backside layer of polysilicon.

6. A semiconducor substrate useful in device manufacturing processes and having capability for gettering defects, contaminants and impurities deleterious to the devices away from the active device region comprising a silicon wafer containing 5 to 50 ppma oxygen and 0.1 to 200 ppba nitrogen.

7. The substrate of Claim 6 wherein said silicon wafer contains 10 to 40 ppma oxygen and 1 to 80 ppba nitrogen.

8. The substrate of Claim 6 wherein said silicon wafer has a backside layer of polysilicon.

9. A process of manufacturing electronic devices using thermal processing conditions wherein the devices are formed on one surface of a substrate comprising a semiconductor material containing oxygen, characterised in that the semiconductor material contains nitrogen in an amount sufficient to enhance the thermal precipitation of said oxygen.

10. A process of Claim 9 wherein the semiconductor material contains 0.1 to 200 ppba nitrogen.

11. A process of Claim 9 wherein the semiconductor material is silicon.

12. A process of Claim 9 wherein the semiconductor material has a layer of polysilicon 0.05 to 5.0 micrometres in thickness on the backside of the wafer.

13. A process of Claim 12 wherein the layer of polysilicon has a thickness of from 0.4 to 1.2 micrometres.

14. A method for controlling oxygen precipitation in a semiconductor substrate comprising doping said substrate with sufficient nitrogen to regulate the oxygen precipitation at selected thermal conditions.

15. The method of Claim 14 wherein the substrate contains 5 to 50 ppma oxygen and 0.1 to 200 ppba nitrogen.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | JOURNAL OF THE ELECTROCHEMICAL SOCIETY, vol. 131, no. 3, March 1984, Manchester, USA; H.-D. CHIOU et al. "Effects of Oxygen and Nitrogen on slip in CZ Silicon Wafers", page 82C, abstract no. 36 | 1-4,6, 7,9-11 | H 01 L 29/167 |
| | --- | | |
| A,D | SOLID STATE TECHNOLOGY, vol. 24, no. 7, July 1981, Port Washington, USA; R.A. CRAVEN et al. "Internal Gettering in Silicon", pages 55-61 <br> * Section "Interaction between carbon and oxygen", pages 59-60 | 1,9 | |
| | --- | | |
| A | PATENT ABSTRACTS OF JAPAN, vol. 8, no. 53, 9th March 1984, page (E-231) (1490); & JP-A-58-206156 (TOKYO SHIBAURA DENKI) 01-12-1983 | 1,9 | **TECHNICAL FIELDS SEARCHED (Int. Cl.4)** <br> H 01 L 21/322 <br> H 01 L 29/167 <br> H 01 L 29/32 |
| | --- | | |
| A,P D | EP-A-0 120 830 (MONSANTO) <br> * Claims 1,2 * | 5,8,12 ,13 | |
| | ----- | | |

The present search report has been drawn up for all claims

| Place of search | Date of completion of the search | Examiner |
|---|---|---|
| BERLIN | 09-07-1985 | GIBBS C.S. |